(19) **Europäisches Patentamt**
**European Patent Office**
**Office européen des brevets**

(11) **EP 2 194 647 B1**

(12) **EUROPEAN PATENT SPECIFICATION**

(45) Date of publication and mention
of the grant of the patent:
**01.08.2012 Bulletin 2012/31**

(51) Int Cl.:
*H03M 13/03* $^{(2006.01)}$     *H03M 13/11* $^{(2006.01)}$

(21) Application number: **08170765.5**

(22) Date of filing: **05.12.2008**

(54) **Generating a seed matrix for LDPC codes**

Erzeugung von Generierungsmatrizen für LDPC-Codes

Génération d'une matrice de graine pour codes LDPC

(84) Designated Contracting States:
**AT BE BG CH CY CZ DE DK EE ES FI FR GB GR HR HU IE IS IT LI LT LU LV MC MT NL NO PL PT RO SE SI SK TR**

(43) Date of publication of application:
**09.06.2010 Bulletin 2010/23**

(73) Proprietor: **Nokia Siemens Networks Oy**
**02610 Espoo (FI)**

(72) Inventors:
- **Cannalire, Giacomo Francesco**
  **20062 Cassano d'Adda (IT)**
- **Mazzucco, Christian**
  **20060 Milano (IT)**

(74) Representative: **Fischer, Michael**
**Nokia Siemens Networks GmbH & Co. KG**
**Intellectual Property Rights**
**P.O. Box 80 17 60**
**81617 München (DE)**

(56) References cited:
**US-A1- 2007 094 582**

- **MILENKOVIC O. ET AL.: "Shortened array codes of large girth" IEEE TRANSACTIONS ON INFORMATION THEORY, vol. 52, no. 8, 1 August 2006 (2006-08-01), pages 3707-3722, XP002516310**

- **MILENKOVIC O. ET AL.: "Regular and irregular low-density parity check codes for iterative decoding based on cylce-invariant difference sets" PROC., THE 41ST ALLERTON CONF. COMMUNICATION, CONTROL AND COMPUTING, MONTICELLO, IL, USA, 1 October 2003 (2003-10-01), - 3 October 2003 (2003-10-03) pages 1700-1701, XP002516311**

- **J-B DORE ET AL: "Cycle and distance properties of structured LDPC codes based on circulant permutation matrices" PROC., 10TH IEEE CANADIAN WORHKSHOP IN INFORMATION THEORY, CWIT '07, 1 June 2007 (2007-06-01), pages 1-4, XP031183052 ISBN: 978-1-4244-0768-2**

- **CHEN ZHIXIONG ET AL: "A construction of linearly encodable QC-LDPC codes by grouping cyclic shift and block elimination" COMPUTING, COMMUNICATION, CONTROL, AND MANAGEMENT, 2008. CCCM '08. ISECS INTERNATIONAL COLLOQUIUM ON, IEEE, PISCATAWAY, NJ, USA, 3 August 2008 (2008-08-03), pages 304-308, XP031314181 ISBN: 978-0-7695-3290-5**

- **LAN LAN ET AL.: "Construction of Quasi-Cyclic LDPC codes for AWGN and binary erasure channels: A finite field approach" IEEE TRANSACTIONS ON INFORMATION THEORY, IEEE, US, vol. 53, no. 7, 1 July 2007 (2007-07-01), pages 2429-2458, XP011186178 ISSN: 0018-9448**

- **LAN L ET AL.: "A trellis-based method for removing cycles from bipartite graphs and construction of lodw density parity check codes" IEEE COMMUNICATIONS LETTERS, IEEE SERVICE CENTER, PISCATAWAY, NJ, US, vol. 8, no. 7, 1 July 2004 (2004-07-01), pages 443-445, XP001200833 ISSN: 1089-7798**

**Description**

The present invention relates to a method and to a system according to the preambles of claims 1 and 7.

*Background Art*

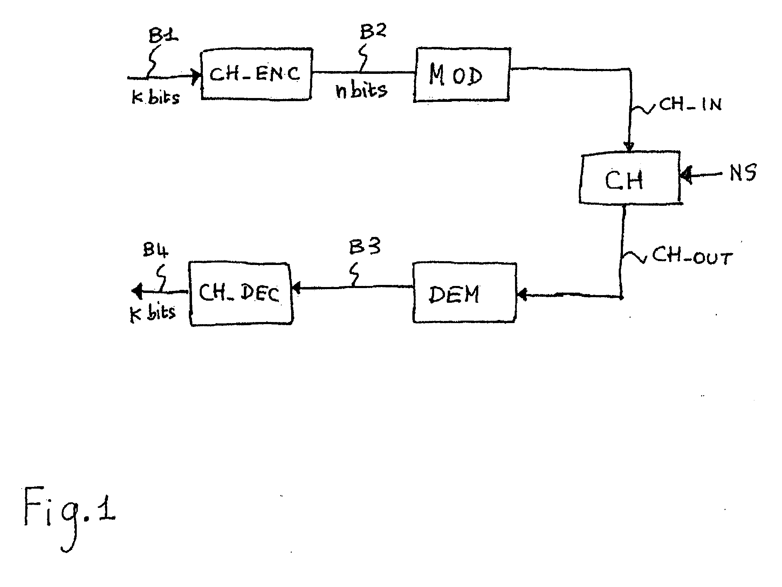

Let us consider a schematic example of a digital communication system model as the one shown in the block diagram of Figure 1.

The input of channel encoder CH_ENC is an information sequence B1 of *k* bits to which a redundancy sequence of *r* bits is added thereby producing an encoded sequence B2 of *n* bits.

The channel code rate *R* is defined as the ratio between the information bits number *k* and the encoded bits number *n*, thus *R = k /n*.

Modulator MOD transforms the encoded vector B2 into a modulated signal vector CH_IN which is in turn transmitted through a channel CH. Since the channel CH is usually subject to noisy disturbance NS, the channel output CH_OUT may differ from the channel input CH_IN.

At the receiving end, the channel output CH_OUT is processed by the demodulator DEM which performs the inverse operation of the modulator MOD and produces some likelihood ratio.

The channel decoder CH_DEC uses the redundancy in the received sequence B3 to correct the error in the information sequence of the received sequence B3 and produces a decoded signal B4 which is an information signal estimate.

State of the art encoder/decoder structures CH_ENC, CH_DEC use codes Low Density Parity Check (LDPC) code as proposed by the IEEE 802.16e Standard for Air Interface For Fixed and Mobile Broadband Wireless Access Systems [Ref.l].

LDPC codes are block codes. Block codes use a generator matrix *G* for the encoding operation and a parity-check matrix *H* for the decoding operation.

For a block code with information sequence of *k* bits, a codeword of *n* bits and redundancy (parity) sequence of *r=(n-k)* bits, the generator matrix *G* has *kxn* dimensions, and the parity-check matrix *H* has *rxn=(n-k)xn* dimensions.

These two matrixes enjoy the orthogonal property, which states that for any matrix $G_{kxn}$ with *k* linearly independent rows there exists a matrix $H_{rxn}$ with *r=(n-k)* linearly independent rows such that any row of $G_{kxn}$ is orthogonal to the rows of $H_{rxn}$ such that the following equation is satisfied:

$$(i)\ G_{kxn}.H^T_{rxn}=0$$

The encoding operation is performed by means of the multiplication between the information sequence $U_{lxk}$ and the code generator matrix $G_{kxn}$. The result, of such multiplication, is the encoded output sequence $V_{lxn}$ as follows:

$$(ii)\ V_{1xn} = U_{1xk} \cdot G_{kxn}$$

At the receiving side, due to the orthogonal property between matrixes $G_{kxn}$ and $H_{rxn}$ the following equation should be satisfied:

$$(iii)\ H_{rxn} \cdot B^T_{nx1} = 0$$

where $B^T_{nx1}$ is the decoded received sequence which comprises the information signal estimate B4. If equation *(iii)* is verified the information signal estimate B4 is correct otherwise the errors in the received sequence B3 exceed the correction capacity of the carried-out code.

Once the code generator matrix $C_{kxn}$ is built, it is possible to obtain the parity-check matrix $H_{rxn}$ and vice versa.

The proposed invention relates to both "channel encoder" and "channel decoder" of Figure 1 for LDPC codes. There are several design techniques for generating the parity-check matrix $H_{rxn}$ of a LDPC code. The most used generating technique in LDPC code design is the semi-random technique,

The parity-check matrix $H_{rxn}$ is built combining in a certain manner three matrixes: the exponent matrix $H_{exp}$ for a specific rate *R*, the seed matrix for the rate *R* and the spreading matrix for a given spreading factor $Z_f$. The element-by-element multiplication of the non-binary exponent matrix $H_{exp}$ with the seed matrix generates another exponent matrix *E* which is in turn expanded to the parity-check matrix $H_{rxn}$, hereby also called expanded matrix $H_{rxn}$, via the spreading

matrix. The spreading matrix is a square binary matrix of weight one and dimension $Z_f x Z_f$, being $Z_f$ the desired spreading factor which is tied to the codeword length of the carried-out LDPC code.

An exponent matrix is a conventional matrix representing a block structured matrix. The elements of the exponent matrix are expanded in square matrixes of dimension $Z_f x Z_f$ by applying the below rules known from the art. The same "expansion" rules apply to the exponent matrix $E$ obtained by multiplicating, element-by-element, the exponent matrix $H_{exp.}$ with the seed matrix.

It is noted that the exponent matrix is typically built with the maximum spreading factor $Z_0$ which corresponds to the maximum codeword size. However, it is possible to implement codewords of variable sizes.

When a different codeword size is desired, e.g. having a size is smaller than the maximum size, a desired spreading factor $Z_f$ smaller than $Z_0$ is required. In such cases, it is possible to convert the exponent matrix built with maximum spreading factor $Z_0$ into an exponent matrix having desired spreading factor $Z_f < Z_0$ by using some translation formulas as, for example, the formula reported in IEEE 802.16e Standard [Ref.1] on page 627 , relation (129a).

The exponent matrix elements with values comprised between $0$ and $(Z_{f-1})$ represent permutation matrixes of the identity matrix (with weight equal to "1" for each row and for each column) with dimensions $Z_f x z_f$. The value of the exponent matrix element indicates the cyclic shift to the right of the identity matrix, as shown in the matrixes $I_{Z_f}^{[0]}$, $I_{Z_f}^{[1]}, ..., I_{Z_f}^{[Z_f-1]}$ below.

All non-negative exponent matrix elements have meaning, for example the zero exponent permutation matrix corresponds to the identity matrix.

$$I_{Z_f}^{[0]} = \begin{bmatrix} 1 & 0 & 0 & 0 & . & 0 & 0 & 0 \\ 0 & 1 & 0 & 0 & . & 0 & 0 & 0 \\ 0 & 0 & 1 & 0 & . & 0 & 0 & 0 \\ 0 & 0 & 0 & 1 & . & 0 & 0 & 0 \\ . & . & . & . & . & . & . & . \\ 0 & 0 & 0 & 0 & . & 1 & 0 & 0 \\ 0 & 0 & 0 & 0 & . & 0 & 1 & 0 \\ 0 & 0 & 0 & 0 & . & 0 & 0 & 1 \end{bmatrix} \qquad I_{Z_f}^{[1]} = \begin{bmatrix} 0 & 1 & 0 & 0 & . & 0 & 0 & 0 \\ 0 & 0 & 1 & 0 & . & 0 & 0 & 0 \\ 0 & 0 & 0 & 1 & . & 0 & 0 & 0 \\ . & . & . & . & . & . & . & . \\ 0 & 0 & 0 & 0 & . & 1 & 0 & 0 \\ 0 & 0 & 0 & 0 & . & 0 & 1 & 0 \\ 0 & 0 & 0 & 0 & . & 0 & 0 & 1 \\ 1 & 0 & 0 & 0 & . & 0 & 0 & 0 \end{bmatrix}$$

$$I_{Z_f}^{[Z_f-1]} = \begin{bmatrix} 0 & 0 & 0 & 0 & . & 0 & 0 & 1 \\ 1 & 0 & 0 & 0 & . & 0 & 0 & 0 \\ 0 & 1 & 0 & 0 & . & 0 & 0 & 0 \\ 0 & 0 & 1 & 0 & . & 0 & 0 & 0 \\ 0 & 0 & 0 & 1 & . & 0 & 0 & 0 \\ . & . & . & . & . & . & . & . \\ 0 & 0 & 0 & 0 & . & 1 & 0 & 0 \\ 0 & 0 & 0 & 0 & . & 0 & 1 & 0 \end{bmatrix}$$

Each element of the exponent matrix of value "-1" conventionally represents a null square matrix of size $Z_f x Z_f$ as shown in matrix $I_{Z_f}^{[-1]}$.

$$I_{Z_f}^{[-1]} = \begin{bmatrix} 0 & 0 & 0 & 0 & . & 0 & 0 & 0 \\ 0 & 0 & 0 & 0 & . & 0 & 0 & 0 \\ 0 & 0 & 0 & 0 & . & 0 & 0 & 0 \\ . & . & . & . & . & . & . & . \\ 0 & 0 & 0 & 0 & . & 0 & 0 & 0 \\ 0 & 0 & 0 & 0 & . & 0 & 0 & 0 \\ 0 & 0 & 0 & 0 & . & 0 & 0 & 0 \\ 0 & 0 & 0 & 0 & . & 0 & 0 & 0 \end{bmatrix}$$

The skilled in the art easily understands that same benefits may be obtained if the cyclic shift is a cyclic shift to the left instead than a one to the right.

It is noted that the term "exponent matrix" is an expression widely used in the art to conventionally denote a matrix whose elements, also called "exponents", represent permutation matrixes of the identity matrix with the given exponent.

Sometimes in the art, the term "exponent" used for the elements of the exponent matrix may be replaced with the equivalent term "shift-size".

Hence, the expanded matrix $H_{rxn}$ is obtained by the above outlined expansion of the exponent matrix $E$. When realized with semi-random technique, the expanded matrix $H_{rxn}$ is constituted of two sub-matrixes: the first sub-matrix is a random matrix having $(n-k)xk = rxk$ size and the second one is a semi-deterministic sub-matrix of $(n-k)x(n-k) = rxr$ size.

The exponent matrix $H_{exp}$ is used in the implementation of both LDPC encoder and LDPC decoder. In the LDPC encoding operation, Method 2 , shown in standard IEEE 802.16e [Ref.1], allows to reduce the LDPC encoder hardware complexity if the exponent matrix $H_{exp}$ is split in opportune sub-matrixes, a random one and a semi-deterministic one: the semi-determininistic sub-matrix is itself split into a semi-deterministic column vector Cv, its first column vector which is constructed in an opportune way, and a deterministic matrix which is typically a bi-diagonal matrix as known from the art.

The Method 2 imposes that the column vector Cv has only three elements different from "-1", representing the null matrix, that the first and the last element are equal and that only one randomly chosen element is equal to "0", representing the identity matrix.

The document D1: Milenkovic O. et al "Shortened Array Codes of Large Girth" may be the closest state of the art; it deals with optimizing of Low Density Parity Check (LDPC) codes, especially with constructing codes of large girth.

### *Technical Problem*

The LDPC codes are decoded by means of an iterative algorithm whose performances tend towards the optimum if the Tanner graph is "cycle-free".

In fact, the presence of cycles of short length produces a performance degradation of the iterative decoding algorithms.

This is due to the fact that these types of algorithms are carried-out by making the assumption of independence between the variables constituting the processed information by every graph node. Several studies show that if the smallest cycle, in the Tanner graph, is equal to $2 \cdot i$ the hypothesis of variable independence is verified for the first $i$ iterations of the decoding algorithm. If the decoding operation is carried-out with an iteration number bigger than $i$, the system performances degrade because, after the $i^{th}$ iteration, the algorithm model hypothesis is not valid anymore.

For the above reason, the cycle which degrades the most the performances of the iterative decoding algorithm is the cycle of length four.

It is therefore the aim of the present invention to overcome the above mentioned performance degradation problems, in particular by providing a method and a system for generating a seed matrix for LDPC codes able of reducing or eliminating the cycles of length four.

### *Tanner graphs*

A Tanner graph is an LDPC code representation which is equivalent to the parity-check matrix $H_{rxn}$.

The Tanner graph is a bipartite graph which is constituted by two node sets; each node of a set can be connected to a node of the other set and it cannot be connected to another node of its own set. The two nodes sets are the bit-nodes and the check-nodes. The bit-nodes are in number equal to the code length $n$ and they are tied to the received codeword bits The check-nodes are in number equal to the parity sequence $r=n-k$ (with $k$ being the information sequence bits) and they are tied to the parity-check equations. Thus, the Tanner graph allows visualizing the existing connection between the received codeword bits and the parity-check equations.

Let us denote by $y_i$ the generic bit-node, placed at the left in the Tanner graph, and by $c_j$ the generic check-node, placed at the right in the graph. The generic bit-node $y_i$ and the generic check-node $c_j$ are connected by means of an edge $e_{i,j}$ if and only if the parity-check matrix $H_{rxn}$ has an element equal to "$1$" in the position $(j,i)$ that is $h_{j,i}=1$.

There is therefore a biunivocal correspondence between the Tanner graph and the parity-check matrix $H_{rxn}$.

Let us consider a simple example, by building a Tanner graph for an exemplary parity-check matrix $H_{6x12}$ as the one shown in equation (1). The parity-check matrix $H_{6x12}$ is built for a LDPC code $(n,k)=(12,6)$ with codeword length $n=12$, information sequence $k=6$, parity sequence $r=n-k=6$ and code rate $R=k/n=1/2$

$$H_{6x12} = \begin{bmatrix} 1 & 1 & 0 & 0 & 0 & 1 & 0 & 0 & 1 & 1 & 0 & 1 \\ 1 & 0 & 0 & 1 & 1 & 0 & 1 & 1 & 0 & 0 & 1 & 0 \\ 0 & 1 & 1 & 0 & 0 & 1 & 1 & 1 & 0 & 0 & 0 & 1 \\ 1 & 0 & 0 & 1 & 1 & 0 & 1 & 0 & 1 & 0 & 0 & 1 \\ 0 & 0 & 1 & 0 & 1 & 1 & 0 & 1 & 0 & 1 & 1 & 0 \\ 0 & 1 & 1 & 1 & 0 & 0 & 0 & 0 & 1 & 1 & 1 & 0 \end{bmatrix} \qquad (1)$$

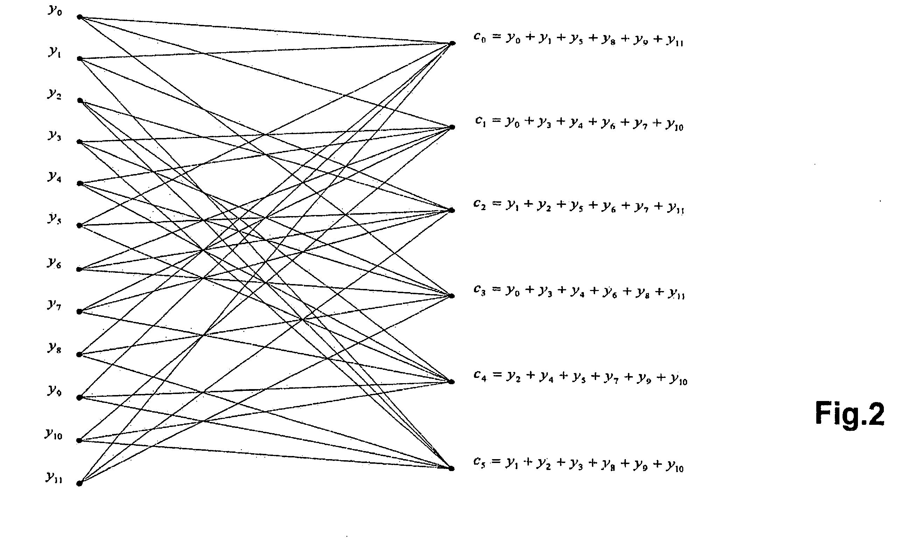

The Tanner graph for LDPC code corresponding to the parity-check matrix $H_{6x12}$ of equation (1) is the graph shown in Figure 2.

Figure 2 illustrates the Tanner graph for LDPC code with exemplary parity-check matrix $H_{6x12}$.

For example, the check-node $c_0$, which corresponds to the first row of the matrix $H_{6x12}$, receives the contributions from the bit-nodes $y_0$, $y_1$, $y_5$, $y_8$, $y_9$, $y_{11}$. In fact, the parity-check matrix elements equal to "$1$" are elements $h_{00}$, $h_{01}$, $h_{05}$, $h_{08}$, $h_{09}$, $h_{0.11}$.

Similarly, the check-node $c_1$, which corresponds to the second row of the matrix $H_{6x12}$, receives the contributions from the bit-nodes $y_0$, $y_3$, $y_4$, $y_7$, $y_7$, $y_{10}$. In fact, the parity-check matrix elements equal to "$1$" are $h_{10}$, $h_{13}$, $h_{14}$, $h_{16}$, $h_{17}$, $h_{1.10}$.

In the same way, the other check-nodes $c_2$, $c_3$, $c_4$, $c_5$ are tied to the respective bit-nodes as shown in Figure 2.

As above outlined in the "Technical Problem" section, in LDPC code design, it is desirable, for performance reasons, that the Tanner graph has zero or only a limited number of length four cycles.

A bipartite Tanner graph is called a cycle-free graph when it has any cycle or closed path, beginning at a node and coming back to the same node by crossing a certain number of graph edges.

The shortest cycle is a cycle of length equal to four, constituted by four edges.

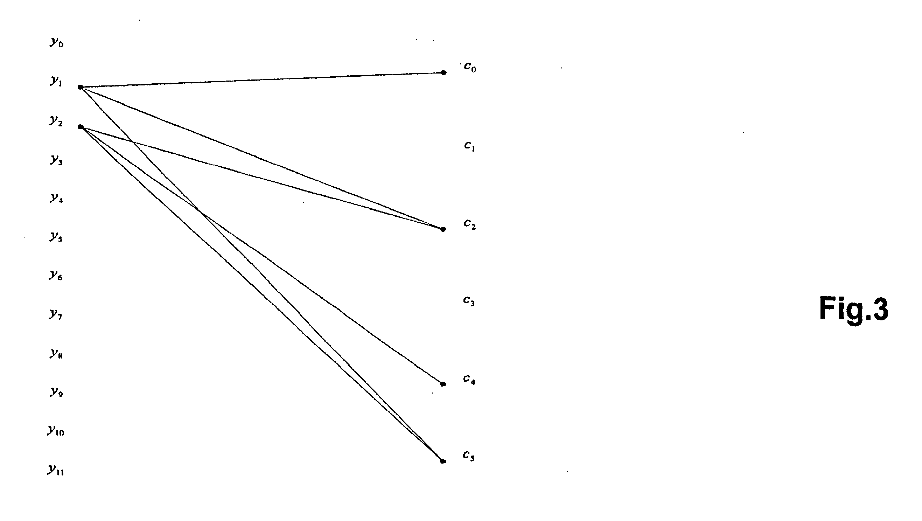

For example, the bit-nodes $y_1$, $y_2$ of the Tanner, which correspond to the second and third columns of the matrix $H_{6x12}$, give rise, together with the check-nodes $c_2$, $c_5$, to a four length cycle as shown in Figure 3. Figure 3 shows the Tanner graph for the second and third columns of the matrix $H_{6x12}$.

In the art, the term overlap, introduced in the domain of matrixes, is generally used to denote a representation of a cycle of any length, e.g. four, six, eight etc. Hereby, the term overlap is used to denote a representation of a four length cycle, since, as above explained, the cycles of length four are the most critical in LDPC code design.

The overlap factor, a counter for overlaps, is defined as the scalar product result between any pair of columns of the expanded (binary) parity-check matrix $H_{6x12}$.

The scalar product of the second and third columns, which correspond to the bit-nodes $y_1$, $y_2$, produces an overlap factor equal to "$2$" because these two columns have both an element equal to "$1$" in the third and sixth rows, which correspond to the check-nodes $c_2$, $c_5$

Having no cycles of length four imply that all possible pairs (couples) of the parity-check matrix columns have no overlap factor greater than "$1$".

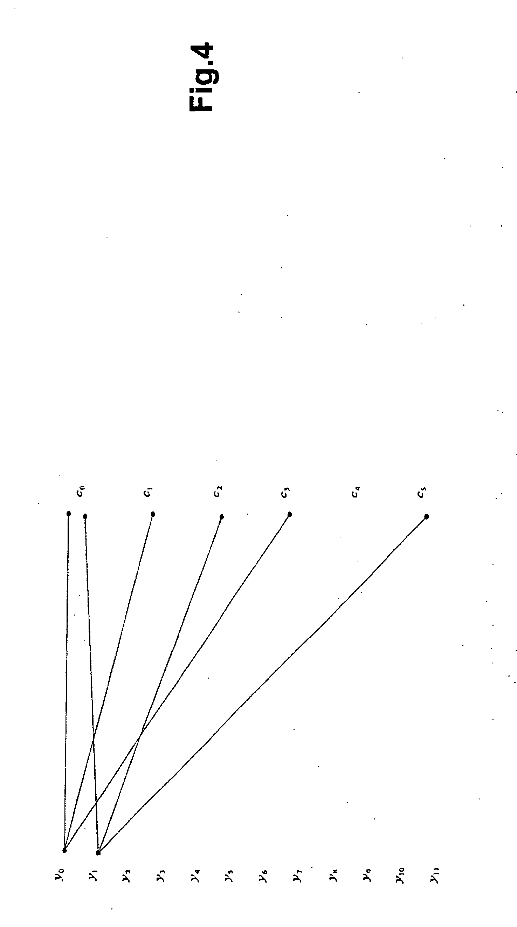

Let us consider, now, the bit-nodes $y_0$, $y_1$, which correspond to first and second columns of the matrix $H_{6x12}$. In this case, as shown in the graph of Figure 4, there are no cycles. In fact, the overlap factor is equal to "$1$", since only the first row, which correspond to the check-node $c_0$, has both elements $h_{00}$, $h_{01}$ equal to "$1$". Figure 4 shows the Tanner graph for the first and second columns of the matrix $H_{6x12}$.

Let us describe the meaning of overlaps and cycles from the point of view of exponent parity check matrixes.

As a numerical example, let us consider a block structured exponent matrix $H_{6x96}^{\exp}$ with block information sequence $k_b=90$, block codeword length $n_b=96$, block parity sequence $r_b=6$, code rate $R=k_b/n_b=(n_b-r_b)/n_b=$

15/16 and spreading factor $Z_0$ = 108. Table 1 shows an example of such block structured exponent matrix ($H_{6,96}^{\mathrm{exp}}$) for LDPC code rate $R_2$ =15/16

Table 1

| r\c | *1* | *2* | *3* | *4* | *5* | *6* | *i* | *85* | *87* | *88* | *89* | *90* | *91* | *92* | *93* | *94* | *95* | *96* |
|-----|-----|-----|-----|-----|-----|-----|-----|------|------|------|------|------|------|------|------|------|------|------|
| *1* | 15 | 17 | **19** | 21 | 23 | 25 | | 93 | **95** | 97 | 99 | 101 | 31 | 0 | -1 | -1 | -1 | -1 |
| *2* | 27 | 30 | 33 | 36 | 39 | 42 | | 5 | 9 | 12 | 15 | 19 | -1 | 0 | 0 | -1 | -1 | -1 |
| *3* | **54** | **59** | 64 | 69 | 74 | 79 | | 43 | 48 | **53** | **58** | 63 | 0 | -1 | 0 | 0 | -1 | -1 |
| *4* | **6** | 7 | 8 | 9 | 10 | 11 | | 3 | 4 | **5** | **6** | 6 | -1 | -1 | -1 | 0 | 0 | -1 |
| *5* | 19 | 23 | **27** | 31 | 35 | 39 | | 100 | **103** | 106 | 2 | 9 | -1 | -1 | -1 | -1 | 0 | 0 |
| *6* | 102 | 0 | 5 | 11 | 17 | 23 | | 33 | 39 | 45 | 51 | 57 | 31 | -1 | -1 | -1 | -1 | 0 |

Let us consider, all possible combinations of row pairs whose number is calculated in relation (2) below.

$$\binom{r_b}{2} = \frac{r_b!}{2! \cdot (r_b - 2)!} = \frac{6!}{2! \cdot 4!} = 15 \tag{1}$$

For each row pair, let us consider all possible combinations of column pairs whose number is calculated in relation (3) below.

$$\binom{n_b}{2} = \frac{n_b!}{2! \cdot (n_b - 2)!} = \frac{90!}{2! \cdot 88!} = 4005 \tag{2}$$

Let us operate with the row pair constituted by the first and second rows. If the condition in relation (4) is satisfied, then the LDPC code has at least one *overlap_factor* = 2 (i.e. one cycle in the Tanner graph).

$$\mathrm{mod}\{[h(1,i) - h(2,i)], Z_f\} = \mathrm{mod}\{[h(1,j) - h(2,j)], Z_f\} \tag{3}$$

Where for each $i$ with $i$=1,2,3, , $k_b$ we will have $j$=$i$+1, $i$+2,.. ,($k_b$ +1).

For each of the other fourteen row pair combinations, the equivalent of relation (4) is checked in order to verify the presence of other four-length cycles.

For example, for the pair constituted by the third and fourth rows, there is an overlap equal to 2 for the first and eighty-eighth columns and for the second and eighty-ninth columns, whose elements are highlighted in bold, since the equivalent of relation (4) is satisfied as shown below:

$$\mathrm{mod}\{[h(3,1) - h(4,1)], Z_0\} = \mathrm{mod}\{[h(3,88) - h(4,88)], Z_0\} = 48$$

$$\mathrm{mod}\{[h(3,2) - h(4,2)], Z_0\} = \mathrm{mod}\{[h(3,89) - h(4,89)], Z_0\} = 52$$

In the same way, the pair constituted by the first and fifth rows has overlap equal to 2, the involved column elements are highlighted in bold type, since the equivalent of condition (3) is verified.

$$\mathrm{mod}\{[h(1,3) - h(5,3)], Z_0\} = \mathrm{mod}\{[h(1,87) - h(5,87)], Z_0\} = 100$$

It is noted that relation (4) and its equivalents verify only the presence of an *overlap_factor* = 2 (that is one only cycle of length four) because the exponents are permutation matrixes of unitary weight; but this *overlap_factor = 2* is valid for all columns of the expanded elements *[h(1,i), h(2,i)]* with *[h(1,j), h(2,j)]*, i.e. for sake of precision, in the expanded binary matrix there will be $Z_f$ column pairs (couples) with *overlap_factor = 2*. However if we operate with all $r_b$ elements of each exponent matrix column pair, then it is possible to obtain an *overda_factor>2;* this case imply more cycles of length four.To verify the presence of cycles bigger than four it is necessary to operate with more of two columns; for example for drive out cycles of length six it is necessary to examine all combinations of three columns of the block structured exponent matrix.Then the maximum length cycle is tied to the exponent matrix row number ($r_b$), in fact it is equal to 2. $r_b$.

In general, by increasing the spreading factor $Z_f$, which implies the increase of the LDPC codeword length, the available distance number among the elements of different rows of the exponent matrix increases.

In the exponent matrix design as known from the art, the procedure is to have in the same row, all possible exponents. In such a way, when bigger is the spreading factor, the bigger is the repetition period of the same exponents inside the same row. Because each matrix row has a different exponent increment also the repetition period of the distances among the exponent matrix rows will grow to the spreading factor increase.

As a consequence, it is more difficult to find two columns of a row pair having the same distance, i.e. it is more difficult that the equivalent of condition (4) is satisfied. This means, it is most probable that the Tanner graph is "cycle-free", i.e. it is mostly likely that the expanded parity-check matrix has *overlap_factor* $\leq 1$

$$Z_f = 27 \qquad dis\tan ces = 0,1,2,.........,26 = (Z_f - 1)$$

$$Z_f = 54 \qquad dis\tan ces = 0,1,2,.........,53 = (Z_f - 1)$$

$$Z_0 = 108 \qquad dis\tan ces = 0,1,2,.........,107 = (Z_0 - 1)$$

The aim of the present invention, as above explained, to overcome the mentioned performance degradation problems, by reducing or eliminating the cycles of length four in the block structured exponent matrix, is achieved by a method and a system for generating a seed matrix to be multiplicated to an exponent matrix for LDPC codes, said LDPC codes being implemented with semi-random technique which requires that the exponent matrix is composed of two sub-matrixes, a random sub-matrix and a semi-deterministic sub-matrix, comprising:

a) performing the following:

- providing a matrix of size $r_b$x($k_b$+1), hereinafter called *BSE_matrix,* constituted by the random part and by the first column vector of the semi-deterministic part of the exponent matrix;

- calculating a distance matrix of size $\binom{r_b}{2}x$ , hereinafter called *D_matrix,* H($k_b$+1) from the *BSE_matrix,* said *D_matrix* keeping track of the distances among all possible combination of the *BSE_matrix* row pairs;
- calculating an overlap counter matrix of size $r_b$x($k_b$+1), hereinafter called *OC_matrix,* from the *D_matrix*, said OC_*matrix* keeping track of overlaps in the *BSE_mutrix,* wherein an overlap represents a four length cycle;

b) performing the following:

- selecting in the *OC_matrix*, an element with the highest value;
- setting in the *BSE_matrix*, a null element, of value "-1", in the location corresponding to the selected element;
- calculating the new updated matrix *D_matrix* from the new *BSE_matrix;*
- calculating the new updated matrix *OC_matrix* from the new *D_matrix.*

c) checking whether item b) is the last iteration otherwise return to item b);
d) calculating the first ($k_b$+1) columns of the seed matrix from the new *BSE_matrix*, by performing the following substeps:

- for each *BSE_matrix* element having value different than "-*1*", the corresponding element in the seed matrix is set to the value "*1*";

- for each *BSE_matrix* element having value equal to "-*1*", the corresponding element in the seed matrix is set to the value "*0*".

In invention embodiments, in item c), it may be checked whether all elements of the matrix *OC_matrix* are zero.

In invention embodiments, item d) may be performed before item c) and in item c) it may be checked whether the mean weight for the columns of the seed matrix reaches a given desired value.

In invention embodiments, the distance matrix *D_matrix* may be calculated from the *ESE_matrix* as follows:

$$ dmj(i) = \mathrm{mod}\left\{ [h(m,i) - h(j,i)], Z_f \right\} \qquad with \quad i = 1,2,3,\ldots\ldots,k_b + 1 $$

and with $m = 1,2,\ldots\ldots, (r_b - 1) = 5$ and $j = m + 1,\ldots\ldots,r_b = 6$

where *dmj* is the generic element of the distance matrix *D_matrix* and *h(m,i)* and *h(j,i)* are the generic elements of the *BSE_matrix.*

In invention embodiments, the overlap counter matrix *DC_matrix* of iem a) may be calculated from the distance matrix *D_matrix* by setting the initial values of the *OC_matrix* elements to zero and then by incrementing the *OC_matrix* elements related to certain *D_matrix* elements as follows:

- when *D_matrix* elements *djx(m)* and *djx(p)* are equal, the *DC_matrix* elements *(j,m),(x,m),(j,p),(x,p)* are incremented.

In invention embodiments, the overlap counter matrix *OC_matrix* of item b) may be calculated from the new *D_matrix* by decrementing the *OC_matrix* elements corresponding to certain updated elements of the matrix *D_matrix.*

It is noted that reducing or eliminating the cycles of length four in the block structured exponent matrix is equivalent of eliminating the cycles of length four in the expanded binary matrix which is used in the LDPC code implementation.

### *Description of embodiments*

The invention will now be described in preferred but not exclusive embodiments with reference to the accompanying drawings, wherein:

Figure 1    is block diagram, already described, schematically illustrating a digital communication system model (Prior Art);

Figure 2    is the Tanner graph, already described, for LDPC code for the exemplary parity-check matrix $H_{6x12}$;

Figure 3    is the Tanner graph, already described, for LDPC code for the second and third columns of the exemplary parity-check matrix $H_{6x12}$;

Figure 4    is the Tanner graph, already described, for LDPC code for the first and second columns of the exemplary parity-check matrix $H_{6x12}$;

Figure 5    is a diagram schematically illustrating a flowchart of the iterative procedure to generate a seed matrix according to an example embodiment of the present invention.

### *Numerical Example*

A simple numerical example according to an embodiment of the present invention is illustrated.

Let us consider the previously described exemplary block structured exponent matrix $H_{6x96}^{exp}$ of Table 1 with block info sequence $k_b = 90$, block codeword length $n_b = 96$, block parity sequence $r_b = 6$, code rate $R = k_b / n_b = (n_b - r_b) / n_b = 15/16$ and spreading factor $Z_0 = 108$.

Table 2

| r/c | 1 | 2 | 3 | 4 | 5 | 6 | i | 41 | 42 | 43 | 44 | 45 | 1 | 86 | 87 | 88 | 89 | 90 | 91 |
|-----|-----|-----|-----|-----|-----|-----|-----|-----|-----|-----|-----|-----|-----|-----|-----|-----|-----|-----|-----|
| 1 | 15 | 17 | 19 | 21 | 23 | 25 | | 92 | 94 | 96 | 98 | 100 | | 93 | 95 | 97 | 99 | 101 | 31 |
| 2 | 27 | 30 | 33 | 36 | 39 | 42 | | 102 | 0 | 4 | 9 | 12 | | 5 | 9 | 12 | 15 | 19 | -1 |
| 3 | 54 | 59 | 64 | 69 | 74 | 79 | | 17 | 21 | 26 | 29 | 30 | | 43 | 48 | 53 | 58 | 63 | 0 |
| 4 | 6 | 7 | 8 | 9 | 10 | 11 | | 107 | 0 | 0 | 1 | 2 | | 3 | 4 | 5 | 6 | 6 | -1 |
| 5 | 19 | 23 | 27 | 31 | 35 | 39 | | 36 | 40 | 43 | 47 | 51 | | 100 | 103 | 106 | 2 | 9 | -1 |
| 6 | 102 | 0 | 5 | 11 | 17 | 23 | | 54 | 60 | 66 | 72 | 78 | | 33 | 39 | 45 | 51 | 57 | 31 |

Table 2 is a numerical example of the random part of the block structured exponent matrix *BSE_matrix* including the semi-deterministic column vector with size $r_b x(k_b + 1)$.

The overlap counter matrix *OC_matrix* of size $r_b x(k_b + 1)$ = 6x91 is a matrix which keeps track of the overlaps in the block structured exponent matrix *BSE_matrix.*

In order to generate the overlap counter matrix *OC_matrix,* a distance matrix *D_matrix* is built first.

The distance matrix *D_matrix* has size $\binom{r_b}{2} x(k_b + 1) = 15x91$ 15x91 and it keeps tracks of the distances among all possible combinations of exponent matrix row pairs.

Table 3

| r\c | 1 | 2 | 3 | 4 | 5 | 6 | i | 41 | 42 | 43 | 44 | 45 | i | 86 | 87 | 88 | 89 | 90 | 91 |
|---|---|---|---|---|---|---|---|---|---|---|---|---|---|---|---|---|---|---|---|
| d12 | 96 | 95 | **94** | 93 | **92** | 91 | | 98 | **94** | **92** | 89 | **88** | | **88** | 86 | 85 | 84 | 82 | -1 |
| d13 | **69** | 66 | 63 | 60 | 57 | 54 | | 75 | 73 | **70** | **69** | **70** | | 50 | 47 | 44 | 41 | 38 | 31 |
| d14 | 9 | 10 | 11 | 12 | 13 | 14 | | **93** | 94 | 96 | 97 | 98 | | 90 | 91 | 92 | **93** | 95 | -1 |
| d15 | 104 | 102 | **100** | 98 | 96 | 94 | | 56 | 54 | 53 | 51 | 49 | | 101 | **100** | 99 | 97 | 92 | -1 |
| d16 | 21 | 17 | 14 | 10 | 6 | 2 | | 38 | 34 | 30 | 26 | 22 | | 60 | 56 | 52 | 48 | 44 | 0 |
| d23 | 81 | 79 | 77 | 75 | 73 | 71 | | 85 | 87 | 86 | 88 | 90 | | 70 | 69 | 67 | 65 | 64 | -1 |
| d24 | 21 | 23 | 25 | 27 | 29 | 31 | | 103 | 0 | 4 | 8 | 10 | | 2 | 5 | 7 | 9 | 11 | -1 |
| d25 | 8 | 7 | 6 | 5 | 4 | 3 | | 66 | 68 | **69** | 70 | **69** | | **13** | **14** | **14** | **13** | 10 | -1 |
| d26 | 33 | 30 | 28 | 25 | 22 | 19 | | **48** | **48** | 46 | 45 | 42 | | 80 | 78 | 75 | 72 | 70 | -1 |
| d34 | **48** | **52** | 56 | 60 | 64 | 68 | | 18 | 21 | 26 | **28** | **28** | | 40 | 44 | **48** | **52** | 57 | -1 |
| d35 | 35 | 36 | 37 | 38 | 39 | 40 | | **89** | **89** | 91 | 90 | 87 | | 51 | 53 | 55 | 56 | 54 | -1 |
| d36 | **60** | **59** | **59** | 58 | 57 | 56 | | 71 | 69 | 68 | 65 | **60** | | 10 | 9 | 8 | 7 | 6 | 77 |
| d45 | 95 | 92 | 89 | 86 | 83 | 80 | | 71 | 68 | 65 | 62 | 59 | | 11 | 9 | 7 | 4 | 105 | -1 |
| d46 | 12 | 7 | 3 | 106 | 101 | 96 | | 53 | 48 | 42 | 37 | 32 | | 78 | 73 | 68 | 63 | 57 | -1 |
| d56 | 25 | 23 | 22 | 20 | 18 | 16 | | 90 | 88 | 85 | 83 | 81 | | 67 | 64 | 61 | 59 | 60 | -1 |

Table 3 is the distance matrix *D_matrix* generated for the block structured matrix $H_{6x96}^{\exp}$ of the above example.

The first row *d12* contains the distances between the first and the second rows of the block structured exponent matrix $H_{6x96}^{\exp}$, computed as follows:

$$d12(i) = \mathrm{mod}\{[h(1,i) - h(2,i)], Z_0\} \qquad with \quad i = 1,2,3,\ldots\ldots,(k_b + 1) = 91$$

Similarly, the second row *d13* contains the distances between the first and the third row of $H_{6x96}^{\exp}$ and so on for each row pair until the last row *d56* which contains the distances between the fifth and the sixth rows of matrix $H_{6x96}^{\exp}$.

In a general form, the elements *dmj* of the distance matrix are computed as following:

$$dmj(i) = \mathrm{mod}\{[h(m,i) - h(j,i)], Z_0\} \qquad with \quad 1 = 1,2,3,\ldots\ldots,(k_b + 1) = 91$$

where *m* =1,2,......, ($r_b$ -1) = 5 and *j* = *m* + 1,......,$r_b$ = 6

In this example, the desired spreading factor is the maximum spreading factor $Z_0$ = 108. In other embodiments of the present invention, the seed matrix may preferably be generated with a desired spreading factor which is the minimum spreading factor so that the seed matrix may be valid for higher desired spreading factors due to the fact that the possible distance number increases.

In the distance matrix *D_matrix* of Table 3 are highlighted in bold and underlined format the elements having one or more elements of equal distance in the same row. Such highlighted elements, taken in pairs of same value in the same row, give rise to an *overlap_ factor = 2* , which is a cycle of *length four* in the Tanner graph.

For example, in the first row *d12,* there are three element pairs having equal distances:

$$d12(3)=d12(42)=94, \; d12(5)=d12(43)=92, \; d12(45)=d12(86)=88 \, .$$

The overlap counter matrix *OC_matrix* is generated by creating a null matrix of size $r_b x(k_b + 1)$ = 6x91 and by incrementing of one some of its elements with the procedure below described.

The elements on the left, corresponding to the elements of the distance matrix *D_matrix* having equal distances pairs in the same row, indicate which elements of the overlap counter matrix are to be incremented.

| *Equal_dis* tan *ces* | *increment* | *OC_matrix_elements* |
|---|---|---|
| *d*12(3) = *d*12(42) = 94 | $\Rightarrow$ | (1,3), (2,3), (1,42), (2,42) |
| *d*12(5) = *d*12(43) = 92 | $\Rightarrow$ | (1,5), (2,5), (1,43), (2,43) |
| *d*12(45) = *d*12(86) = 88 | $\Rightarrow$ | (1,45), (2,45), (1,86), (2,86) |

| *Equal_dis* tan *ces* | *increment* | *OC_ matrix_elements* |
|---|---|---|
| *d*13(1) = *d*13(44) = 69 | $\Rightarrow$ | (1,1), (3,1), (1,44), (3,44) |
| *d*13(43) = *d*13(45) = 70 | $\Rightarrow$ | (1,43), (3,43), (1,45), (3,45) |

The procedure is repeated until the last row of the distance matrix having equal distance s is reached, e.g. *d36*

| *Equal_ dis* tan *ces* | *increment* | *OC_ matrix_ elements* |
|---|---|---|
| *d*36(1) = *d*36(45) = 60 | $\Rightarrow$ | (3,1), (6,1), (3,45), (6,45) |
| *d*36(2) = *d*36(3) = 59 | $\Rightarrow$ | (3,2),(6,2),(3,3),(6,3) |

The above procedure can be expressed in a more general form as follows:

| *Equal_dis* tan *ces* | *increment* | *OC_matrix_ elements* |
|---|---|---|
| *djx(m) = djx(p)* | $\Rightarrow$ | *(j,m), (x,m), (J,p), (x,p)* |

The result is the generation of the overlap counter matrix *OC_matrix.* The overlap matrix elements are to be interpreted as follows. When an element greater than zero is present, for example of value 1, this element is to be read tied together with another element of value 1 (or greater) present in the same row but in another column but also tied together with two elements of another row in the same column positions and such quartet represents one cycle of length four (or one overlap of value 2).

An element of value 2 or more represents 2 or more cycles of length four read in combination with two or more elements on the same row and with two or more couple of elements the other rows. For this reasons, in an overlap counter matrix *OC_matrix,* the sum of the element values on the same row is always an even number.

Table 4 shows the overlap counter matrix *OC_matrix* of size $r_b x(k_b + 1) = 6x91$ generated for the above example.

Table 4

| r/c | **1** | **2** | **3** | **4** | **5** | **6** | **i** | **41** | **42** | **43** | **44** | **45** | **i** | **86** | **87** | **88** | **89** | **90** | **91** |
|-----|---|---|---|---|---|---|---|---|---|---|---|---|---|---|---|---|---|---|---|
| **1** | 1 | 0 | 2 | 0 | 1 | 0 | | 1 | 1 | 2 | 1 | 2 | | 1 | 1 | 0 | 1 | 0 | 0 |
| **2** | 0 | 0 | 1 | 0 | 1 | 0 | | 1 | 2 | 2 | 0 | 2 | | 2 | 1 | 1 | 1 | 0 | 0 |
| **3** | 3 | 2 | 1 | 0 | 0 | 0 | | 1 | 1 | 1 | 2 | 3 | | 0 | 0 | 1 | 1 | 0 | 0 |
| **4** | 1 | 1 | 0 | 0 | 0 | 0 | | 1 | 0 | 0 | 1 | 1 | | 0 | 0 | 1 | 2 | 0 | 0 |
| **5** | 0 | 0 | 1 | 0 | 0 | 0 | | 1 | 1 | 1 | 0 | 1 | | 1 | 2 | 1 | 1 | 0 | 0 |
| **6** | 1 | 1 | 1 | 0 | 0 | 0 | | 1 | 1 | 0 | 0 | 1 | | 0 | 1 | 0 | 0 | 0 | 0 |

### Generation of the seed-matrix

The iterative procedure exemplified below illustrates the generation of a seed matrix so that the overlaps are reduced, and, for this specific example, eliminated:

### 1st Iteration

The steps to follow in the first iteration, for reducing the number of cycles having length four, are listed below:

Step A

Selecting, in the matrix *OC_matrix,* the element with the highest value, i.e. the highest overlap level. For example, in the matrix *OC_matrix* of Table 4, there are two elements having the highest value, e.g. value "*3*", such elements have coordinates (3,1) and (3,45). In this example, the first encountered element (3,1) of the pair is chosen as the selected element. In other embodiments of the present invention, when one or more elements have the same highest value, another element than the first highest encountered element may be chosen.

Step B

Setting, in the matrix *BSE_matrix*, a null element, i.e. an element having value "-*1*", in the location corresponding to the selected highest element from the matrix *OC_matrix.* In this example, the element with coordinates (3,1) is set to the value "-*1*" as shown in Table 5 in the grey shaded element. Table 4 illustrates the matrix *BSE_matrix* after the first iteration.

| r\c | 1 | 2 | 3 | 4 | 5 | 6 | i | 41 | 42 | 43 | 44 | 45 | i | 86 | 87 | 88 | 89 | 90 | 91 |
|---|---|---|---|---|---|---|---|---|---|---|---|---|---|---|---|---|---|---|---|
| 1 | 15 | 17 | 19 | 21 | 23 | 25 | | 92 | 94 | 96 | 98 | 100 | | 93 | 95 | 97 | 99 | 101 | 31 |
| 2 | 27 | 30 | 33 | 36 | 39 | 42 | | 102 | 0 | 4 | 9 | 12 | | 5 | 9 | 12 | 15 | 19 | -1 |
| 3 | -1 | 59 | 64 | 69 | 74 | 79 | | 17 | 21 | 26 | 29 | 30 | | 43 | 48 | 53 | 58 | 63 | 0 |
| 4 | 6 | 7 | 8 | 9 | 10 | 11 | | 107 | 0 | 0 | 1 | 2 | | 3 | 4 | 5 | 6 | 6 | -1 |
| 5 | 19 | 23 | 27 | 31 | 35 | 39 | | 36 | 40 | 43 | 47 | 51 | | 100 | 103 | 106 | 2 | 9 | -1 |
| 6 | 102 | 0 | 5 | 11 | 17 | 23 | | 54 | 60 | 66 | 72 | 78 | | 33 | 39 | 45 | 51 | 57 | 31 |

Table 5

Step C

Computing the updated distance matrix *D_matrix* from the new updated *BSE_matrix,* taking into account that, in the first column, the elements having exponent matrix row pair containing the third row do not require to be calculated, being the exponent matrix element *(3,1)* equal to the null matrix "-*1*". Such elements are set to the conventional value "-*1*", e.g. the elements *d13(1), d23(1), d34(1), d35(1)* and *d36(1)*. From these five elements, three of them where previously marked (e.g. highlights in Table 3) as having an overlap of 2 (e.g. a four length cycle) and as a consequence, also the associated exponent distances *d13(44)=69, d34(88)=48* and *d36(45)=60* have not anymore an overlap of size two (a four length cycle).

Table 6 shows the matrix *D_matrix* after the first iteration. The elements in the matrix *D_matrix* which produce a decrement in the matrix *OC_matrix* are shown with gray shading in Table 6.

| r\c | 1 | 2 | 3 | 4 | 5 | 6 | i | 41 | 42 | 43 | 44 | 45 | i | 86 | 87 | 88 | 89 | 90 | 91 |
|---|---|---|---|---|---|---|---|---|---|---|---|---|---|---|---|---|---|---|---|---|
| d12 | 96 | 95 | **94** | 93 | **92** | 91 | | 98 | **94** | **92** | 89 | **88** | | **88** | 86 | 85 | 84 | 82 | -1 |
| d13 | -1 | 66 | 63 | 60 | 57 | 54 | | 75 | 73 | **70** | **69** | **70** | | 50 | 47 | 44 | 41 | 38 | 31 |
| d14 | 9 | 10 | 11 | 12 | 13 | 14 | | **93** | 94 | 96 | 97 | 98 | | 90 | 91 | 92 | **93** | 95 | -1 |
| d15 | 104 | 102 | **100** | 98 | 96 | 94 | | 56 | 54 | 53 | 51 | 49 | | 101 | **100** | 99 | 97 | 92 | -1 |
| d16 | 21 | 17 | 14 | 10 | 6 | 2 | | 38 | 34 | 30 | 26 | 22 | | 60 | 56 | 52 | 48 | 44 | 0 |
| d23 | -1 | 79 | 77 | 75 | 73 | 71 | | 85 | 87 | 86 | 88 | 90 | | 70 | 69 | 67 | 65 | 64 | -1 |
| d24 | 21 | 23 | 25 | 27 | 29 | 31 | | 103 | 0 | 4 | 8 | 10 | | 2 | 5 | 7 | 9 | 11 | -1 |
| d25 | 8 | 7 | 6 | 5 | 4 | 3 | | 66 | 68 | **69** | 70 | **69** | | **13** | **14** | **14** | **13** | 10 | -1 |
| d26 | 33 | 30 | 28 | 25 | 22 | 19 | | **48** | **48** | 46 | 45 | 42 | | 80 | 78 | 75 | 72 | 70 | -1 |
| d34 | -1 | **52** | 56 | 60 | 64 | 68 | | 18 | 21 | 26 | **28** | **28** | | 40 | 44 | **48** | **52** | 57 | -1 |
| d35 | -1 | 36 | 37 | 38 | 39 | 40 | | **89** | **89** | 91 | 90 | 87 | | 51 | 53 | 55 | 56 | 54 | -1 |
| d36 | -1 | **59** | *59* | 58 | 57 | 56 | | 71 | 69 | 68 | 65 | **60** | | 10 | 9 | 8 | 7 | 6 | 77 |
| d45 | 95 | 92 | 89 | 86 | 83 | 80 | | 71 | 68 | 65 | 62 | 59 | | 11 | 9 | 7 | 4 | 105 | -1 |
| d46 | 12 | 7 | 3 | 106 | 101 | 96 | | 53 | 48 | 42 | 37 | 32 | | 78 | 73 | 68 | 63 | 57 | -1 |
| d56 | 25 | 23 | 22 | 20 | 18 | 16 | | 90 | 88 | 85 | 83 | 81 | | 67 | 64 | 61 | 59 | 60 | -1 |

Table 6

Step D

Decrementing the *OC_matrix* element corresponding to the gray shaded updated elements of the matrix *D_*

*matrix,* as follows:

| updated D_matrix elements | ⇒ | decremented OC matrix elements |
|---|---|---|
| d13(1) [involves d13(44)] | | (1,1), (3,1), (1,44), (3,44) |
| d34(1) [involves d34(88)] | | (3,1), (4,1), (3,88), (4,88) |
| d36(1) [involves d36(45)] | | (3,1), (6,1), (3,45), (6,45) |

In this case, then, the *OC matrix* element *(3,1)* is decremented of 3 while the elements *(1,1), (4,1), (6,1), (1,44), (3,44), (3,45), (6,45), (3,88), (4,88)* are decremented of "*1*".

Let us express with a more general notation the relationship between the shaded elements from matrix *D-matrix* and the elements in matrix *OC_matrix* to be decremented as follows:

| updated D matrix element | => | decremented OC matrix elements |
|---|---|---|
| dij(m) [involves dij(m+1)] | | (i,m)), (j,m), (i,m+l), (j,m+1) |

Table 7 shows the matrix *OC_matrix* after the first iteration.

The *OC_matrix* elements, which are shown in Table 7, shaded in gray, have achieved an overlap number reduction with the first iteration. Advantageously, by setting a single *BSE_matrix* element to "-*1*" (null matrix), three cycles of length four have been eliminated.

The elimination of one cycle of length four produces a decrement for four memory locations of the *DC_matrix* (a couple in a row and a couple in another row that is a couple in a column and a couple in another column).

| r\c | 1 | 2 | 3 | 4 | 5 | 6 | i | 41 | 42 | 43 | 44 | 45 | i | 86 | 87 | 88 | 89 | 90 | 91 |
|---|---|---|---|---|---|---|---|---|---|---|---|---|---|---|---|---|---|---|---|
| 1 | 0 | 0 | 2 | 0 | 1 | 0 | | 1 | 1 | 2 | 0 | 2 | | 1 | 1 | 0 | 1 | 0 | 0 |
| 2 | 0 | 0 | 1 | 0 | 1 | 0 | | 1 | 2 | 2 | 0 | 2 | | 2 | 1 | 1 | 1 | 0 | 0 |
| 3 | 0 | 2 | 1 | 0 | 0 | 0 | | 1 | 1 | 1 | 1 | 2 | | 0 | 0 | 0 | 1 | 0 | 0 |
| 4 | 0 | 1 | 0 | 0 | 0 | 0 | | 1 | 0 | 0 | 1 | 1 | | 0 | 0 | 0 | 2 | 0 | 0 |
| 5 | 0 | 0 | 1 | 0 | 0 | 0 | | 1 | 1 | 1 | 0 | 1 | | 1 | 2 | 1 | 1 | 0 | 0 |
| 6 | 0 | 1 | 1 | 0 | 0 | 0 | | 1 | 1 | 0 | 0 | 0 | | 0 | 0 | 0 | 0 | 0 | 0 |

Table 7

It is convenient to specify that if some semi-deterministic column element ($k_b$+1=91_*BSE_matrix_column*) is "overlapped" (that is involved in a cycle of length four), it is necessary to put "-*1*" (null matrix) the other corresponding *BSE_matrix* element which produces the overlap = 2 (*four_length-cycle*); this last element will be placed in one of the previous columns, between *1* and $k_b$ = 90. In this way the semi-deterministic column vector maintains its peculiar characteristics which allow having, in the semi-random technique, an LDPC encoder with a low complexity hardware.

An overlap represents a four length cycle which ties four *ESE_matrix* elements and produces an increment for each of the four corresponding *OC_matrix* elements. In the *BSE_matrix*, by placing one of these four elements to "-*1*" (null matrix) the four length cycle is eliminated and, in the *OC_matrix*, the corresponding element is set to the value "-*1*" while the other three elements are decremented.

An overlap (or four length cycle) is represented, in the *BSE_matrix* and in the *OC_matrix*, by a rectangle constituted from two elements on two rows that correspond to two elements on two columns.

### 2nd Iteration

In the second iteration, the steps are as follows:

Step A

Selecting, in the matrix *DC_matrix,* the element with the highest value, i.e. the highest overlap level. For example, in the matrix *DC_matrix* of Table7, there are many elements having the highest value, e.g. value "*2*", such elements have coordinates *(3,2), (1,3), ....., (5,87),(4,89)* . In this example, the first encountered element *(3,2)* of such elements is chosen as the selected element.

Step B

Setting, in the matrix *ESE_matrix,* a null element, i.e. an element having value "-*1*", in the location corresponding to the selected highest element from the matrix *OC_matrix.* In this example, the element with coordinates *(3,2)* is set to the value "-*1*" as shown in Table 8 by highlighting the element. Table 8 illustrates the matrix *BSE_matrix* after the second iteration.

Table 8

| r\c | 1 | 2 | 3 | 4 | 5 | 6 | i | 41 | 42 | 43 | 44 | 45 | l | 86 | 87 | 88 | 89 | 90 | 91 |
|---|---|---|---|---|---|---|---|---|---|---|---|---|---|---|---|---|---|---|---|
| 1 | 15 | 17 | 19 | 21 | 23 | 25 | | 92 | 94 | 96 | 98 | 100 | | 93 | 95 | 97 | 99 | 101 | 31 |
| 2 | 27 | 30 | 33 | 36 | 39 | 42 | | 102 | 0 | 4 | 9 | 12 | | 5 | 9 | 12 | 15 | 19 | -1 |
| 3 | -1 | -1 | 64 | 69 | 74 | 79 | | 17 | 21 | 26 | 29 | 30 | | 43 | 48 | 53 | 58 | 63 | 0 |
| 4 | 6 | 7 | 8 | 9 | 10 | 11 | | 107 | 0 | 0 | 1 | 2 | | 3 | 4 | 5 | 6 | 6 | -1 |
| 5 | 19 | 23 | 27 | 31 | 35 | 39 | | 36 | 40 | 43 | 47 | 51 | | 100 | 103 | 106 | 2 | 9 | -1 |
| 6 | 102 | 0 | 5 | 11 | 17 | 23 | | 54 | 60 | 66 | 72 | 78 | | 33 | 39 | 45 | 51 | 57 | 31 |

Step C

Calculating the *D_matrix* elements except for the elements which were previously set to "-1" and for the elements, in the second column, having exponent matrix row pair containing the third row being the exponent matrix element *(3,2)* equal to the null matrix "-*1*". Such elements are set to the value "-*1*", e.g. the elements *d13(2), d23(2), d34(2), d35(2)* and *d36(2)*. From these five elements, two of them where previously marked (e.g. by highlight in Table 6) as having an overlap of size two (or a four length cycle) and as a consequence, also the associated exponent distances *d34(89)=69* and *d36(3)=59* have not anymore an overlap of size two (or a four length cycle).

Table 9 shows the matrix *D_matrix* after the second iteration.

The corresponding *D_matrix* elements which produce an OC matrix decrement are shown as gray shaded elements in Table 9.

| r\c | *1* | *2* | *3* | *4* | *5* | *6* | *i* | *41* | *42* | *43* | *44* | *45* | *i* | *86* | *87* | *88* | *89* | *90* | *91* |
|---|---|---|---|---|---|---|---|---|---|---|---|---|---|---|---|---|---|---|---|
| *d12* | 96 | 95 | **94** | 93 | **92** | 91 | | 98 | **94** | **92** | 89 | **88** | | **88** | 86 | 85 | 84 | 82 | -1 |
| *d13* | -1 | **-1** | 63 | 60 | 57 | 54 | | 75 | 73 | **70** | 69 | **70** | | 50 | 47 | 44 | 41 | 38 | 31 |
| *d14* | 9 | 10 | 11 | 12 | 13 | 14 | | **93** | 94 | 96 | 97 | 98 | | 90 | 91 | 92 | **93** | 95 | -1 |
| *d15* | 104 | 102 | **100** | 98 | 96 | 94 | | 56 | 54 | 53 | 51 | 49 | | 101 | **100** | 99 | 97 | 92 | -1 |
| *d16* | 21 | 17 | 14 | 10 | 6 | 2 | | 38 | 34 | 30 | 26 | 22 | | 60 | 56 | 52 | 48 | 44 | 0 |
| *d23* | -1 | **-1** | 77 | 75 | 73 | 71 | | 85 | 87 | 86 | 88 | 90 | | 70 | 69 | 67 | 65 | 64 | -1 |
| *d24* | 21 | 23 | 25 | 27 | 29 | 31 | | 103 | 0 | 4 | 8 | 10 | | 2 | 5 | 7 | 9 | 11 | -1 |
| *d25* | 8 | 7 | 6 | 5 | 4 | 3 | | 66 | 68 | **69** | 70 | **69** | | **13** | **14** | **14** | **13** | 10 | -1 |
| *d26* | 33 | 30 | 28 | 25 | 22 | 19 | | **48** | **48** | 46 | 45 | 42 | | 80 | 78 | 75 | 72 | 70 | -1 |
| *d34* | -1 | **-1** | 56 | 60 | 64 | 68 | | 18 | 21 | 26 | **28** | **28** | | 40 | 44 | 48 | **52** | 57 | -1 |
| *d35* | -1 | **-1** | 37 | 38 | 39 | 40 | | **89** | **89** | 91 | 90 | 87 | | 51 | 53 | 55 | 56 | 54 | -1 |
| *d36* | -1 | **-1** | **59** | 58 | 57 | 56 | | 71 | 69 | 68 | 65 | 60 | | 10 | 9 | 8 | 7 | 6 | 77 |
| *d45* | 95 | 92 | 89 | 86 | 83 | 80 | | 71 | 68 | 65 | 62 | 59 | | 11 | 9 | 7 | 4 | 105 | -1 |
| *d46* | 12 | 7 | 3 | 106 | 101 | 96 | | 53 | 48 | 42 | 37 | 32 | | 78 | 73 | 68 | 63 | 57 | -1 |
| *d56* | 25 | 23 | 22 | 20 | 18 | 16 | | 90 | 88 | 85 | 83 | 81 | | 67 | 64 | 61 | 59 | 60 | -1 |

Table 9

Step D

Decrementing the *OC_matrix* element corresponding to the gray shaded updated elements of the matrix *D_matrix,* as follows:

| updated D matrix elements | ⇒ | decremented OC matrix elements |
|---|---|---|
| *d34(2) [involves d34(89)]* | | *(3,2), (4,2), (3,89), (4,89)* |
| *d36(2) [involves d36(3)]* | | *(3,2), (6,2), (3,3), (6,3)* |

In this case, then, the *OC matrix* element *(3,1)* is decremented of "*2*" while elements *(4,2), (6,2), (3,3), (6,3), (3,89), (4,89)* are decremented of "*1*".

Table 10 shows the matrix *OC_matrix* after the second iteration.

The *OC_matrix* elements shown in Table 10 as gray shaded have achieved an overlap number reduction with the second iteration.

Advantageously, by setting a single *BSE_matrix* element to "-*1*" (null matrix), two overlaps of size two have been eliminated in the matrix *DC_matrix.*

Two overlap of size two correspond to two cycles of length four and then to eight decrements in the *OC_matrix*

$$2\_cycles \cdot four\_length = 2 \cdot 4 = 8\_OC\_matrix\_decrements$$

$$3\_cycles \cdot four\_length = 3 \cdot 4 = 12\_OC\_matrix\_decrements$$

| r\c | 1 | 2 | 3 | 4 | 5 | 6 | i | 41 | 42 | 43 | 44 | 45 | i | 86 | 87 | 88 | 89 | 90 | 91 |
|---|---|---|---|---|---|---|---|---|---|---|---|---|---|---|---|---|---|---|---|
| 1 | 0 | 0 | 2 | 0 | 1 | 0 | | 1 | 1 | 2 | 0 | 2 | | 1 | 1 | 0 | 1 | 0 | 0 |
| 2 | 0 | 0 | 1 | 0 | 1 | 0 | | 1 | 2 | 2 | 0 | 2 | | 2 | 1 | 1 | 1 | 0 | 0 |
| 3 | 0 | 0 | 0 | 0 | 0 | 0 | | 1 | 1 | 1 | 1 | 2 | | 0 | 0 | 0 | 0 | 0 | 0 |
| 4 | 0 | 0 | 0 | 0 | 0 | 0 | | 1 | 0 | 0 | 1 | 1 | | 0 | 0 | 0 | 1 | 0 | 0 |
| 5 | 0 | 0 | 1 | 0 | 0 | 0 | | 1 | 1 | 1 | 0 | 1 | | 1 | 2 | 1 | 1 | 0 | 0 |
| 6 | 0 | 0 | 0 | 0 | 0 | 0 | | 1 | 1 | 0 | 0 | 0 | | 0 | 0 | 0 | 0 | 0 | 0 |

Table 10

### 3rd Iteration

In the third iteration, the steps are as follows:

Step A

Selecting, in the matrix *OC_matrix,* the element with the highest value, i.e. the highest overlap level. For example, in the matrix *OC_matrix* of Table 10, there are many elements having the highest value, e.g. value "2", such elements have coordinates *(1,3), (2,42), .... , (2,86), (5,87)*. In this example, the first encountered element *(1,3)* of such elements is chosen as the selected element.

Step B

Setting, in the matrix *BSE_matrix*, a null element, i.e. an element having value "-*1*", in the location corresponding to the selected highest element from the matrix *OC_matrix*. In this example, the element with coordinates *(1,3)* is set to the value "-*1*" as shown in Table 11 by highlighting the element. Table 11 illustrates the matrix *BSE_matrix* after the third iteration.

Table 11 shows *BSE_matrix* after the third iteration

Table 11

| r\c | 1 | 2 | 3 | 4 | 5 | 6 | i | 41 | 42 | 43 | 44 | 45 | i | 86 | 87 | 88 | 89 | 90 | 91 |
|---|---|---|---|---|---|---|---|---|---|---|---|---|---|---|---|---|---|---|---|
| 1 | 15 | 17 | -1 | 21 | 23 | 25 | | 92 | 94 | 96 | 98 | 100 | | 93 | 95 | 97 | 99 | 101 | 31 |
| 2 | 27 | 30 | 33 | 36 | 39 | 42 | | 102 | 0 | 4 | 9 | 12 | | 5 | 9 | 12 | 15 | 19 | -1 |
| 3 | -1 | -1 | 64 | 69 | 74 | 79 | | 17 | 21 | 26 | 29 | 30 | | 43 | 48 | 53 | 58 | 63 | 0 |
| 4 | 6 | 7 | 8 | 9 | 10 | 11 | | 107 | 0 | 0 | 1 | 2 | | 3 | 4 | 5 | 6 | 6 | -1 |
| 5 | 19 | 23 | 27 | 31 | 35 | 39 | | 36 | 40 | 43 | 47 | 51 | | 100 | 103 | 106 | 2 | 9 | -1 |
| 6 | 102 | 0 | 5 | 11 | 17 | 23 | | 54 | 60 | 66 | 72 | 78 | | 33 | 39 | 45 | 51 | 57 | 31 |

Step C

Computing newly the *D_matrix* elements except for the elements which were previously set to "-1" and for the elements, in the third column, having exponent matrix row pair containing the first row being the exponent matrix element *(1,3)* equal to the null matrix "*-1*". Such elements are set to the value "*-1*", e.g. elements *d12, d13, d14, d15* and *d16*. From these five elements, two of them where previously marked (e.g. by highlight in Table 9 as having an overlap of size two (e.g. a four length cycle) and as a consequence, also the associated exponent distances *d12(42)=94* and *d15 (87)=100* have not anymore an overlap of size two (a four length cycle).

Table 12 shows the matrix *D_matrix* after the third iteration. In Table 13, the elements in the matrix *D_matrix* which produce a decrement in the matrix *OC_matrix* are shown with gray shading.

| *r\c* | *1* | *2* | *3* | *4* | *5* | *6* | *i* | *41* | *42* | *43* | *44* | *45* | *i* | *86* | *87* | *88* | *89* | *90* | *91* |
|---|---|---|---|---|---|---|---|---|---|---|---|---|---|---|---|---|---|---|---|
| *d12* | 96 | 95 | -1 | 93 | 92 | 91 | | 98 | 94 | 92 | 89 | 88 | | 88 | 86 | 85 | 84 | 82 | -1 |
| *d13* | -1 | -1 | -1 | 60 | 57 | 54 | | 75 | 73 | 70 | 69 | 70 | | 50 | 47 | 44 | 41 | 38 | 31 |
| *d14* | 9 | 10 | -1 | 12 | 13 | 14 | | 93 | 94 | 96 | 97 | 98 | | 90 | 91 | 92 | 93 | 95 | -1 |
| *d15* | 104 | 102 | -1 | 98 | 96 | 94 | | 56 | 54 | 53 | 51 | 49 | | 101 | 100 | 99 | 97 | 92 | -1 |
| *d16* | 21 | 17 | -1 | 10 | 6 | 2 | | 38 | 34 | 30 | 26 | 22 | | 60 | 56 | 52 | 48 | 44 | 0 |
| *d23* | -1 | -1 | 77 | 75 | 73 | 71 | | 85 | 87 | 86 | 88 | 90 | | 70 | 69 | 67 | 65 | 64 | -1 |
| *d24* | 21 | 23 | 25 | 27 | 29 | 31 | | 103 | 0 | 4 | 8 | 10 | | 2 | 5 | 7 | 9 | 11 | -1 |
| *d25* | 8 | 7 | 6 | 5 | 4 | 3 | | 66 | 68 | 69 | 70 | 69 | | 13 | 14 | 14 | 13 | 10 | -1 |
| *d26* | 33 | 30 | 28 | 25 | 22 | 19 | | 48 | 48 | 46 | 45 | 42 | | 80 | 78 | 75 | 72 | 70 | -1 |
| *d34* | -1 | -1 | 56 | 60 | 64 | 68 | | 18 | 21 | 26 | 28 | 28 | | 40 | 44 | 48 | 52 | 57 | -1 |
| *d35* | -1 | -1 | 37 | 38 | 39 | 40 | | 89 | 89 | 91 | 90 | 87 | | 51 | 53 | 55 | 56 | 54 | -1 |
| *d36* | -1 | -1 | 59 | 58 | 57 | 56 | | 71 | 69 | 68 | 65 | 60 | | 10 | 9 | 8 | 7 | 6 | 77 |
| *d45* | 95 | 92 | 89 | 86 | 83 | 80 | | 71 | 68 | 65 | 62 | 59 | | 11 | 9 | 7 | 4 | 105 | -1 |
| *d46* | 12 | 7 | 3 | 106 | 101 | 96 | | 53 | 48 | 42 | 37 | 32 | | 78 | 73 | 68 | 63 | 57 | -1 |
| *d56* | 25 | 23 | 22 | 20 | 18 | 16 | | 90 | 88 | 85 | 83 | 81 | | 67 | 64 | 61 | 59 | 60 | -1 |

Table 12

Step D

Decrementing the *OC_matrix* element corresponding to the gray shaded updated elements of the matrix *D_matrix,* as follows:

| *updated D matrix elements* | ⇒ | *decremented OC matrix elements* |
|---|---|---|
| *d12(3) [involves d12(42)]* | | *(1, 3), (2,3), (1,42), (2,42)* |
| *d15(3) [involves d15(87)]* | | *(1,3), (5,3), (1,87), (5,87)* |

In this case, then, the *OC matrix* element *(1,3)* is decremented of "*2*" while the elements *(2,3), (5,3), (1,42), (2,42), (1,87), (5,87)* are decremented of "*1*".

Table 13 shows the matrix *OC-matrix* after the third iteration.

The *OC_matrix* elements shown in Table 13 as gray shaded have achieved an overlap number reduction with the third iteration.

| r\c | 1 | 2 | 3 | 4 | 5 | 6 | I | 41 | 42 | 43 | 44 | 45 | i | 86 | 87 | 88 | 89 | 90 | 91 |
|---|---|---|---|---|---|---|---|---|---|---|---|---|---|---|---|---|---|---|---|
| 1 | 0 | 0 | 0 | 0 | 1 | 0 | | 1 | 0 | 2 | 0 | 2 | | 1 | 0 | 0 | 1 | 0 | 0 |
| 2 | 0 | 0 | 0 | 0 | 1 | 0 | | 1 | 1 | 2 | 0 | 2 | | 2 | 1 | 1 | 1 | 0 | 0 |
| 3 | 0 | 0 | 0 | 0 | 0 | 0 | | 1 | 1 | 1 | 1 | 2 | | 0 | 0 | 0 | 0 | 0 | 0 |
| 4 | 0 | 0 | 0 | 0 | 0 | 0 | | 1 | 0 | 0 | 1 | 1 | | 0 | 0 | 0 | 1 | 0 | 0 |
| 5 | 0 | 0 | 0 | 0 | 0 | 0 | | 1 | 1 | 1 | 0 | 1 | | 1 | 1 | 1 | 1 | 0 | 0 |
| 6 | 0 | 0 | 0 | 0 | 0 | 0 | | 1 | 1 | 0 | 0 | 0 | | 0 | 0 | 0 | 0 | 0 | 0 |

Table 13

Also in this case two cycles of length four, which correspond to eight decrements of the *OC_matrix* memory locations, have been eliminated.

$$\underline{4^a, 5^a, 6^a, .........l - th - iteration}$$

The algorithm proceeds iteratively until all elements of the matrix $OC\_matrix$ are zero.

In further embodiments of the present invention, the iterative procedure may be ended when other conditions are reached. For example, a condition may be the reaching of a given column mean weight.

In fact, in the design of the seed matrix it is important to take into account the column weight $w_c$ because it is tied to the LDPC code performances and to the design specifications. The design concept consists in dimensioning opportunely the column mean weight (semi-random technique) of the seed matrix columns denoted as $w_c$.

The column mean weight $w_c$ is calculated as follows:

$$w_c = \left\{ \sum_{i=1}^{r_b} \sum_{j=1}^{n_b} H^{seed}(i,j) \right\} / n_b$$

Such column mean weight may preferably be not too high to avoid considerable hardware complexity (remarkable logic-arithmetic operation number) but also not too low to avoid bad performances (error floor presence).

Thus, the value of the given column mean weight $w_c$ may be associated to the desired error floor of the design specification. In an exemplary embodiment, the column mean weight $w_c$ may be set to be between 4 and 5.

A compromise is sought between a high $w_c$ which results in good performances (i.e. error floor absence) but considerable hardware complexity and a low $w_c$ which reduces the hardware complexity but implies bad performances (i.e. error floor presence).

The LDPC code performances are estimated with the BER- SNR curve: where the curve changes the slope there is the error floor which means that the BER is almost constant at the growing of the SNR ratio.

If all the elements of the *OC_matrix* are reduced to zero (i.e. all cycles of length four have been eliminated) and the mean weight of the seed matrix columns $w_c$ is bigger than the value which assures the design specification performances, it is preferred to reduce in uniform way, but randomly, the seed matrix column weight; for example, by reducing the columns with weight *(x)* and *(x+1)* to weight *(x-1)* and *(x)* respectively, while the exponent matrix continues to be without cycles of length four.

If once of all the elements of the *OC_matrix* are reduced to zero and the mean weight of the seed matrix columns results to be lower than the value which assures the design spec performances, it is suggested not to reduce to zero all *OC_matrix* elements but to stop the procedure when the desired $w_c$ value is reached. In this case, only simulations will tell if the achieved performances fit the design specifications; given that certainly the LDPC code performances will be degraded, compared to the assured therethical performances when no four length cycle is present.

In order to reduce the number of cycles of length four, the IEEE 802.16e standard [1] proposes to build the exponent matrix with a column number equal to the minimum spreading factor ($n_b = Z_{f-min}$). In this case, since there are not more spreading factor periods inside each exponent matrix row, then cycles of length four are possibly avoided since there are not repetition periods.

On the contrary, in the proposed invention, the spreading factor may be much smaller than the exponent matrix column number ($Z_{f\_min} < n_b$) and still cycles of length four can be avoided.

It is howver noted that, the lower the spreading factor $Z_{f\text{-}min}$, the lower will be the mean column mean weight $w_c$ necessary until all four length cycles are eliminated from the exponent matrix. Thus, in the our design the minimum spreading factor ($Z_{f\_min}$) will be what allows to have mean weight $w_c$ equal to the value that assures the design specification performances.

For exemplification purposes, let us assume that, after the last iteration, the resulting matrix *BSE_matrix* is the one shown in Table 14.

Table 14

| rlc | 1 | 2 | 3 | 4 | 5 | 6 | i | 41 | 42 | 43 | 44 | 45 | i | 86 | 87 | 88 | 89 | 90 | 91 |
|---|---|---|---|---|---|---|---|---|---|---|---|---|---|---|---|---|---|---|---|
| 1 | 15 | 17 | -1 | 21 | 23 | 25 | | 92 | 94 | 96 | 98 | -1 | | 93 | 95 | 97 | 99 | 101 | 31 |
| 2 | 27 | 30 | 33 | 36 | 39 | 42 | | 102 | 0 | -1 | 9 | 12 | | -1 | 9 | 12 | 15 | 19 | -1 |
| 3 | -1 | -1 | 64 | 69 | 74 | 79 | | 17 | 21 | 26 | 29 | 30 | | 43 | 48 | 53 | 58 | 63 | 0 |
| 4 | 6 | 7 | 8 | 9 | 10 | 11 | | -1 | 0 | 0 | -1 | 2 | | 3 | 4 | 5 | 6 | 6 | -1 |
| 5 | 19 | 23 | 27 | 31 | 35 | 39 | | -1 | 40 | 43 | 47 | 51 | | 100 | -1 | 106 | 2 | 9 | -1 |
| 6 | 102 | 0 | 5 | 11 | 17 | 23 | | 54 | -1 | 66 | 72 | 78 | | 33 | 39 | 45 | 51 | 57 | 31 |

The first ($k_b+1$) columns of the seed matrix $H^{seed}$ are derived by the block structured exponent matrix $ESE\_matrix$ after the last iteration as follows:

- for each $BSE\_matrix$ element having value different than "-1", the corresponding element in the seed matrix $H^{seed}$ is set to the value "1";

- for each $BSE\_matrix$ element having value equal to "-1", the corresponding element in the seed matrix $H^{seed}$ is set to the value "0".

The first ($k_b+1$) columns of the binary seed matrix $H^{seed}$, extracted by the matrix $BSE\_matrix$ of Table 14, is shown in Table 15.

Table 15 shows the first ($k_b+1$) columns of the binary seed matrix $H^{seed}$ for LDPC code with block information sequence $k_b$ = 90, codeword length $n_b$ = 96, parity sequence $r_b$ = 6, spreading factor $Z_0$ =108 and code rate $R= k_b/n_b = (n_b - r_b)/n_b$ =15/16 for the above example.

Table 15

| r\c | 1 | 2 | 3 | 4 | 5 | 6 | i | 41 | 42 | 43 | 44 | 45 | i | 86 | 87 | 88 | 89 | 90 | 91 |
|-----|---|---|---|---|---|---|---|----|----|----|----|----|---|----|----|----|----|----|----|
| 1 | 1 | 1 | 0 | 1 | 1 | 1 | | 1 | 1 | 1 | 1 | 0 | | 1 | 1 | 1 | 1 | 1 | 1 |
| 2 | 1 | 1 | 1 | 1 | 1 | 1 | | 1 | 1 | 0 | 1 | 1 | | 0 | 1 | 1 | 1 | 1 | 0 |
| 3 | 0 | 0 | 1 | 1 | 1 | 1 | | 1 | 1 | 1 | 1 | 1 | | 1 | 1 | 1 | 1 | 1 | 1 |
| 4 | 1 | 1 | 1 | 1 | 1 | 1 | | 0 | 1 | 1 | 0 | 1 | | 1 | 1 | 1 | 1 | 1 | 0 |
| 5 | 1 | 1 | 1 | 1 | 1 | 1 | | 0 | 1 | 1 | 1 | 1 | | 1 | 0 | 1 | 1 | 1 | 0 |
| 6 | 1 | 1 | 1 | 1 | 1 | 1 | | 1 | 0 | 1 | 1 | 1 | | 1 | 1 | 1 | 1 | 1 | 1 |

The parity-check matrix $H_{rxn}$ is then built by combining the exponent matrix $H_{exp}$ for a specific rate $R$, the generated seed matrix $H^{seed}$ for the same specific rate $R$ generated and the spreading matrix for a given spreading factor $Z_f$ as known from the art.

### Simplified algorithm flowchart

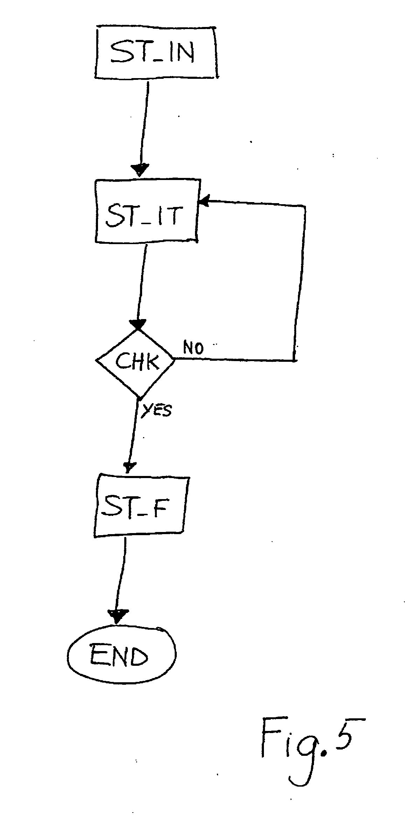

Figure 5 is a simplified diagram schematically illustrating a flowchart of the iterative procedure to generate a seed matrix according to an example embodiment of the present invention.

At an initialization step INIT, the following sub-steps are performed:

- providing matrix $BSE\_matrix$, constituted by the random part and the first column vector of the semi-deterministic part of a block structured exponent matrix;
- calculating a distance matrix $D\_matrix$ from the $BSE\_matrix$;
- calculating the overlap counter matrix $OC\_matrix$ from the $D\_matrix$,.

At step ST_IT, the following sub-steps are performed:

- in the $OC\_matrix$, an element with the highest value is selected;
- in the $BSE\_matrix$, a null element - of value "-1" - is set in the location corresponding to the selected element;
- calculating the new updated matrix $D\_matrix$ from the new $BSE\_matrix$;
- calculating the new updated matrix OC_matrix from the new $D\_matrix$.

At conditional check CHK, it is checked whether the previously performed step is the last iteration YES or whether another iteration is to be performed NO.

**[0154]** In case it is not the last iteration, the step ST_IT is performed again, in an iterative way, until the conditional check CHK return result true YES.

In case the conditional check CHK return true YES, the final step ST_F before the end END is performed, in which the seed matrix $H^{seed}$ is calculated.

It is noted that in the above description of the exemplary embodiment of the present invention, the distance matrix is calculated newly at every iteration. The skilled in the art easily understands that in further embodiments of the present invention, the distance matrix may be updated at every iteration by updating only certain distance matrix elements, such embodiments however require that the distance matrix elements are characterized by at least two parameters. For example, each distance matrix element may be characterized by two parameters: the first parameter is the exponent distance and the second one indicates how many other elements of that row have the same distance.

Then a *D_matrix* element can be indicated in this way:

$$d_{ij}(m) = par_1, par_2$$

where $par_1$ is the exponent distance between the *i* and *j* of the *BSE_matrix* while $par_2$ is the sum, decremented by one, of the *D_matrix* elements which have the same distance

| $par_2$ | $D\_matrix\_element$ | Meaning |
|---|---|---|
| 0 | $d_{ij}(m) = par_i, 0$ | this element isn't "overlapped", that is there aren't other elements, in the same row, which have distance $par_i$ |
| 1 | $d_{ij}(m) = par_i, 1$ | there is only another element, in the same row, which has distance $par_i$ |
| 2 | $d_{ij}(m) = par_i, 2$ | there are other two elements, in the same row, which have distance $par_i$ |
| ... | ......... | .............. |
| q | $d_{ij}(m) = par_i, q$ | there are other *q* elements, in the same row, which have distance $par_i$ |

If we are in the case where ($d_{ij}(m) = par_i, 1$) and ($d_{ij}(m + x_1) = par_i, 1$), with ($x_1 > 0$) and ($m + x_1 \leq k_b + 1$), and we put, for example, the *BSE_matrix* (*j,m*) element equal to "-*1*", we will have $d_{ij}(m)$="-1" (but also $d_{1j}(m) = d_{2j}(m) = ......$ $= d_{j,rb}(m)$ ="-1" with *i*=1,2,...,$r_b$ but $i \neq j$) and $d_{ij}(m+x_1) = par_i, 0$.

Then when we update the *OC_matrix*, the (*j,m*) element becomes zero because all its overlaps are erased and moreover all other *m* column overlaps, which involves the BSE_matrix *j* row, are decremented by one; for the ($m + x_1$) column only the elements in the *i* and *j* rows are decremented by one.

If we are in the case where ($d_{ij}(m) = par_i, 2$), ($d_{ij}(m + x_1) = par_i, 2$) and ($d_{ij}(m + x_1 + x_2) = par_i, 2$), with ($x_1 > 0$), ($x_2 > 0$) and ($m + x_1 + x_2 \leq k_b + 1$), and we put, for example, the *BSE_matrix* (*j,m*) element equal to "-*1*", we will have $d_{ij}(m)$ = "-1" (but also $d_{1j}(m) = d_{2j}(m) = ...... = d_{j,rb}(m)$ ="-1" with *i*=1,2,...,$r_b$ but $i \neq j$), $d_{ij}(m + x_1) = par_i, 1$ and $d_{ij}(m + x_1 + x_2) = par_i, 1$.

Then when we update the *OC_matrix*, the (*j,m*) element becomes zero because all its overlaps are erased and moreover all other *m* column overlaps, which involves the *BSE_matrix j* row, are decremented by one; for the ($m + x_1$) and ($m + x_1 + x_2$) columns the elements in the *i* and *j* rows aren't decremented because the overlap parameter ($par_2$) isn't yet zero but it's only decremented by 2 to 1 indicating again an overlap presence in that *D_matrix* row.

Then the conclusion is that if the (*j,m*) element of the *BSE_matrix* is placed to the "-*1*" value this makes equal to zero, in the *D_matrix*, its parameter $par_2$ while the other "overlapped" elements, in the same *D_matrix* row, decrement of one their parameter $par_2$; only when $par_2$ is zero we decrement the overlap elements (*i,m+x_1*) and (*j,m+x_1*) or (*i, m+x_1+x_2*) and (*j,m+x_1+x_2*) of the *OC_matrix*.

### References

[Ref.1] IEEE 802.16e Standard for Air Interface For Fixed and Mobile Broadband Wireless Access Systems - 28 February 2006

### *Used acronyms*

BER Bit Error Rate
LDPC Low Density Parity Check
SNR Signal to Noise Ratio

**Claims**

1. A method for generating a seed matrix to be multiplied to an exponent matrix for LDPC codes for usage in an LDPC encoder/decoder said LDPC codes being implemented with semi-random technique which requires that the exponent matrix is composed of two sub-matrixes, a random sub-matrix and a semi-deterministic sub-matrix, the method being **characterized in that** it comprises the steps of:

   a) performing (ST_IN) the following initialization substeps:

   - providing a matrix of size $r_b$x($k_b$+1), hereinafter called *BSE_matrix,* constituted by the random part and by the first column vector of the semi-deterministic part of the exponent *matrix, $r_b$* being the block parity sequence *and $k_b$* being the block information sequence;

   - calculating a distance matrix of size $\binom{r_b}{2}$x$\left( k_b +1 \right)$,, hereinafter called *D_matrix,* from the *BSE_matrix,* said *D_matrix* keeping track of the distances among all possible combination of the *BSE_matrix* row pairs;
   - calculating an overlap counter matrix of size $r_b$x($k_b$+1), hereinafter called *OC_matrix,* from the *D_matrix,* said *OC_matrix* keeping track of overlaps in the *BSE_matrix,* wherein an overlap represents a four length cycle;

   b) performing (ST_IT) the following substeps:

   - selecting in the *OC_matrix,* an element with the highest value;
   - setting in the *BSE_matrix,* a null element, of value "-1", in the location corresponding to the selected element;
   - calculating the new updated matrix *D_matrix* from the new *BSE_matrix;*
   - calculating the new updated matrix *OC_matrix* from the new *D_matrix.*

   c) checking by using a stopping condition (CHK) whether step b) is the last iteration otherwise return to step b);
   d) calculating (ST_F) the first ($k_b$+1) columns of the seed matrix from the new *BSE_matrix,* by performing the following substeps:

   - for each *BSE_matrix* element having value different than "-*1*", the corresponding element in the seed matrix is set to the value "*1*";
   - for each *BSE_matrix* element having value equal to "-1", the corresponding element in the seed matrix is set to the value "0".

2. The method according to claim 1, wherein in step c) it is checked whether all elements of the matrix *OC_matrix* are zero.

3. The method according to claim 1, wherein step d) is performed before step c) and wherein in step c) it is checked whether the mean weight for the columns of the seed matrix reaches a given desired value.

4. The method according to any of the preceding claims, wherein the distance matrix *D_matrix* is calculated from the *BSE_matrix* as follows:

$$dmj(i) = \mathrm{mod}\{[h(m,i) - h(j,i)], Z_f\} \qquad with \quad i = 1,2,3,.........,k_b +1$$

and with $m$ =1,2,......, ($r_b$-1)= 5 and $j$ = $m$ + 1,......,$r_b$ = 6
where *dmj* is the generic element of the distance matrix *D_matrix* and *h(m,i)* and *h(j,i)* are the generic elements of the *BSE_matrix.*

5. The method according to any of the preceding claims, wherein the overlap counter matrix *OC_matrix* in step a) is calculated from the distance matrix *D_matrix* by setting the initial values of the *OC_matrix* elements to zero and then by incrementing the *OC_matrix* elements related to certain *D_matrix* elements as follows:

- when *D_matrix* elements *djx(m)* and *djx(p)* are equal, the *OC_matrix* elements *(j,m),(x,m),(j,p),(x,p)* are incremented.

6. The method according to any of the preceding claims, wherein the overlap counter matrix *OC_matrix* in step b) is calculated from the new *D_matrix* by decrementing the *OC_matrix* elements corresponding to certain updated elements of the matrix *D_matrix.*

7. A system having means for performing the steps of the method according to any of the claims 1 to 6.

**Patentansprüche**

1. Verfahren zum Erzeugen einer zu einer Exponentenmatrix für LDPC-Codes zur Verwendung in einem LDPC-Codierer/Decodierer zu multiplizierenden Seed-Matrix, wobei die LDPC-Codes mit einer halb zufälligen Technik ausgeführt werden, die erfordert, dass die Exponentenmatrix aus zwei Teilmatritzen, einer zufälligen Teilmatrix und einer halb deterministischen Teilmatrix, zusammengesetzt wird,
   wobei das Verfahren **dadurch gekennzeichnet ist, dass** es die folgenden Schritte aufweist:

   a) Durchführen (ST_IN) der folgenden Initialisierungsteilschritte:

   - Bereitstellen einer Matrix mit der Größe $r_b x(k_b+1)$, nachfolgend BSE_matrix genannt, die aus dem zufälligen Teil und aus dem Vektor der ersten Spalte des halb deterministischen Teils der Exponentenmatrix besteht, wobei $r_b$ die Blockparitätsfolge ist und $k_b$ die Blockinformationsfolge ist;

   - Berechnen einer Distanzmatrix mit der Größe $\binom{r_b}{2} x (k_b + 1)$, , nachfolgend D_matrix genannt, von der BSE_matrix, wobei die D_matrix die Distanzen zwischen allen möglichen Kombinationen der BSE_matrix-Zeilenpaare verfolgt;
   - Berechnen einer Überlappungszählermatrix mit der Größe $r_b x(k_b+1)$, nachfolgend OC_matrix genannt, von der D_matrix, wobei die OC_matrix Überlappungen in der BSE_matrix verfolgt, wobei eine Überlappung einen Zyklus mit der Länge vier darstellt;

   b) Durchführen (ST_IT) der folgenden Teilschritte:

   - Auswählen eines Elements mit dem höchsten Wert in der OC_matrix;
   - Einstellen eines Nullelements mit dem Wert "-1" an der Stelle, die dem ausgewählten Element entspricht, in der BSE_matrix;
   - Berechnen der neuen aktualisierten Matrix D_matrix von der neuen BSE_matrix;
   - Berechnen der neuen aktualisierten Matrix OC_matrix von der neuen D_matrix;

   c) Prüfen (CHK), ob Schritt b) die letzte Iteration ist, unter Verwendung einer Haltbedingung, und anderenfalls Rückkehren zu Schritt b);
   d) Berechnen (ST_F) der ersten ($k_b+1$) Spalten der Seed-Matrix von der neuen BSE_matrix durch Durchführen der folgenden Teilschritte:

   - für jedes BSE_matrix-Element, das einen Wert aufweist, der sich von "-1" unterscheidet, wird das entsprechende Element in der Seed-Matrix auf den Wert "1" eingestellt;
   - für jedes BSE_matrix-Element, das einen Wert gleich "-1" aufweist, wird das entsprechende Element in der Seed-Matrix auf den Wert "0" eingestellt;

2. Verfahren nach Anspruch 1, wobei in Schritt c) geprüft wird, ob alle Elemente der Matrix OC_matrix null sind.

3. Verfahren nach Anspruch 1, wobei Schritt d) vor Schritt c) durchgeführt wird und wobei in Schritt c) geprüft wird, ob das mittlere Gewicht für die Spalten der Seed-Matrix einen gegebenen gewünschten Wert erreicht.

4. Verfahren nach einem der vorhergehenden Ansprüche, wobei die Distanzmatrix D_matrix wie folgt von der BSE_matrix berechnet wird:

$$dmj(i) = mod\{[h(m,i) - h(j,i)], 2_i\} \text{ mit } i = 1, 2, 3, \ldots, k_b+1$$

und mit $m$=1, 2, ..., $(r_b- 1)$ = 5 und $j$=$m$+1, ..., $r_b$ = 6

wo *dmj* das generische Element der Distanzmatrix D_matrix ist und *h(m,i)* und *h(j,i)* die generischen Elemente der BSE_matrix sind.

**5.** Verfahren nach einem der vorhergehenden Ansprüche, wobei die Überlappungszählermatix OC_matrix in Schritt a) von der Distanzmatrix D_matrix berechnet wird, indem die Anfangswerte der OC_matrix-Elemente auf null eingestellt werden und dann die OC_matrix-Elemente, die mit bestimmten D_matrix-Elementen verbunden sind, wie folgt inkrementiert werden:

- wenn die D_matrix-Elemente *djx(m)* und *djx(p)* gleich sind, werden die OC_matrix-Elemente *(j,m)*, *(x,m)*, *(j, p)*, *(x,p)* inkrementiert.

**6.** Verfahren nach einem der vorhergehenden Ansprüche, wobei die Überlappungszählermatix OC-matrix in Schritt b) von der neuen D_matrix durch Dekrementieren der OC_matrixElemente berechnet wird, die bestimmten aktualisierten Elementen der Matrix D_matrix entsprechen.

**7.** System, das Mittel zum Durchführen der Schritte des Verfahrens nach einem der Ansprüche 1 bis 6 aufweist.

**Revendications**

**1.** Un procédé de génération d'une matrice de départ destinée à être multipliée vers une matrice d'exposants pour codes LDPC pour une utilisation dans un codeur/décodeur LDPC, lesdits codes LDPC étant mis en oeuvre avec une technique semi-aléatoire qui exige que la matrice d'exposants soit composée de deux sous-matrices, une sous-matrice aléatoire et une sous-matrice semi-déterministe,

le procédé étant **caractérisé en ce qu'**il comprend les opérations suivantes :

a) l'exécution (ST_IN) des sous-opérations d'initialisation suivantes :

- la fourniture d'une matrice de dimension $r_b$x$(k.b+1)$, ci-après appelée matrice *BSE_matrix*, constituée par la partie aléatoire et par le vecteur de première colonne de la partie semi-déterministe de la matrice d'exposants, $r_b$ étant la séquence de parité de bloc et $k_b$ étant la séquence d'informations de bloc,

- le calcul d'une matrice de distance de dimension $\binom{r_b}{2}x(k_b+1)$, ci-après appelée matrice *D_matrix*, à partir de la matrice *ESE_matrix,* ladite matrice *D_matrix* gardant une trace des distances parmi toutes les combinaisons possibles des paires de lignes de la matrice *BSE_matrix*,

- le calcul d'une matrice de compteur de chevauchements de dimension $r_b$x$(k_b+1)$, ci-après appelée matrice *OC_matrix,* à partir de la matrice *D_matrix,* ladite matrice *OC_matrix* gardant une trace des chevauchements dans la matrice *BSE_matrix,* dans laquelle un chevauchement représente un cycle de longueur quatre,

b) l'exécution (ST_IT) des sous-opérations suivantes :

- la sélection, dans la matrice *OC_matrix,* d'un élément avec la valeur la plus élevée,
- la définition, dans la matrice *BSE_matrix,* d'un élément nul, de valeur "-1", dans l'emplacement correspondant à l'élément sélectionné,
- le calcul de la nouvelle matrice actualisée *D_matrix* à partir de la nouvelle matrice *BSE_matrix,*
- le calcul de la nouvelle matrice actualisée *OC_matrix* à partir de la nouvelle matrice *D_matrix.*

c) la vérification, au moyen d'une condition d'arrêt (CHK), si l'opération b) est la dernière itération, dans le cas contraire, le retour à l'opération b),
d) le calcul (ST_F) des premières colonnes $(k_b+1)$ de la matrice de départ à partir de la nouvelle matrice *BSE_matrix* par l'exécution des sous-opérations suivantes :

- pour chaque élément de la matrice *BSE_matrix* possédant une valeur différente de "-*1*", l'élément correspondant dans la matrice de départ est réglé sur la valeur "1",
- pour chaque élément de la matrice *BSE_matrix* possédant une valeur égale à "-*1*", l'élément correspondant dans la matrice de départ est réglé sur la valeur "0".

2. Le procédé selon la revendication 1, dans lequel à l'opération c) il est vérifié si tous les éléments de la matrice *OC_matrix* sont zéro.

3. Le procédé selon la revendication 1, dans lequel l'opération d) est exécutée avant l'opération c) et dans lequel à l'opération c) il est vérifié si le poids moyen pour les colonnes de la matrice de départ atteint une valeur souhaitée donnée.

4. Le procédé selon l'une quelconque des revendications précédentes, dans lequel la matrice de distance *D_matrix* est calculée à partir de la matrice *BSE_matrix* comme suit :

$$dmj(i) = \mathrm{mod}\{[h(m,i) - h(j,i)], Z_f\} \quad \text{avec } i = 1,2,3,......,k_b + 1$$

et avec $m$ = 1,2,......, ($r_b$ -1) = 5 et $j$ = $m$+1,......,$rb$ = 6 où *dmj* est l'élément générique de la matrice de distance *D_matrix* et $h(m, i)$ et $h(j, i)$ sont les éléments génériques de la matrice *BSE_matrix.*

5. Le procédé selon l'une quelconque des revendications précédentes, dans lequel la matrice de compteur de chevauchements *OC_matrix* à l'opération a) est calculée à partir de la matrice de distance *D_matrix* par le réglage des valeurs initiales des éléments de la matrice *OC_matrix* sur zéro et ensuite par l'incrémentation des éléments de la matrice *OC_matrix* en relation avec certains éléments de la matrice *D_matrix* comme suit :

- lorsque les éléments de la matrice *D_matrix djx(m)* et *djx(p)* sont égaux, les éléments de la matrice *OC_matrix (j, m), (x, m), (j, p), (x,p)* sont incrémentés.

6. Le procédé selon l'une quelconque des revendications précédentes, dans lequel la matrice de compteur de chevauchements *OC_matrix* à l'opération b) est calculée à partir de la nouvelle matrice *D_matrix* par la décrémentation des éléments de la matrice *OC_matrix* correspondant à certains éléments actualisés de la matrice *D_matrix.*

7. Un système équipé d'un moyen destiné à l'exécution des opérations du procédé selon l'une quelconque des revendications 1 à 6.

Fig.1

EP 2 194 647 B1

$$c_0 = y_0 + y_1 + y_5 + y_8 + y_9 + y_{11}$$

$$c_1 = y_0 + y_3 + y_4 + y_6 + y_7 + y_{10}$$

$$c_2 = y_1 + y_2 + y_5 + y_6 + y_7 + y_{11}$$

$$c_3 = y_0 + y_3 + y_4 + y_6 + y_8 + y_{11}$$

$$c_4 = y_2 + y_4 + y_5 + y_7 + y_9 + y_{10}$$

$$c_5 = y_1 + y_2 + y_3 + y_8 + y_9 + y_{10}$$

**Fig.2**

EP 2 194 647 B1

Fig.3

Fig.4

Fig.5